Europäisches Patentamt

(19) European Patent Office

Office européen des brevets

(11) Veröffentlichungsnummer: **0 043 040**

**A1**

(12) **EUROPÄISCHE PATENTANMELDUNG**

(21) Anmeldenummer: **81104699.4**

(22) Anmeldetag: **19.06.81**

(51) Int. Cl.³: **H 05 K 9/00**
**H 01 B 1/20, H 01 B 5/16**

(30) Priorität: **01.07.80 DE 3024888**

(43) Veröffentlichungstag der Anmeldung:
**06.01.82 Patentblatt 82/1**

(84) Benannte Vertragsstaaten:
**CH DE FR GB IT LI**

(71) Anmelder: **BAYER AG**
**Zentralbereich Patente, Marken und Lizenzen**
**D-5090 Leverkusen 1, Bayerwerk(DE)**

(72) Erfinder: **Ebneth, Harold, Dr.**
**Berta-von-Suttner-Strasse 61**
**D-5090 Leverkusen(DE)**

(72) Erfinder: **Fitzky, Hans Georg, Dr.**
**Adolf-Kolping-Strasse 7**
**D-5068 Odenthal(DE)**

(72) Erfinder: **Oberkirch, Wolfgang, Dr.**
**Gerstenkamp 14**
**D-5000 Köln 80(DE)**

(54) **Verbundmaterial zur Abschirmung elektromagnetischer Strahlung.**

(57) Ein Verbundmaterial, in dessen Polymermatrix metallisierte (5) textile Flächengebilde (6) und oder metallisierte Teilchen enthalten sind und außerdem gleichmäßig im Polymer und/oder auf dem textilen Flächengebilde und/oder Teilchen Additive zur Erhöhung der ohmschen, elektrischen und/oder magnetischen Verluste vorhanden sind, hat eine hohe Schirmwirkung für elektromagnetische Strahlung sowohl im Nah- als auch im Fernfeld in einem großen Frequenzbereich.

FIG. 3

EP 0 043 040 A1

BAYER AKTIENGESELLSCHAFT    5090 Leverkusen, Bayerwerk
                                                          Hö/bc/c
Zentralbereich
Patente, Marken und Lizenzen


Verbundmaterial zur Abschirmung elektromagnetischer
Strahlung
_____

Aufgabe einer elektromagnetischen Schirmung ist es,
die in einen bestimmten Raum eingestrahlte Energie
oder die aus einem Raum emittierte elektromagnetische
Strahlung auszuschalten oder zumindest zu mindern.
Solche Abschirmungen werden in vielfältiger Weise
zur Vermeidung der Einstreuung in Leitungen und elektronische Schaltungen, zur Unterdrückung unzulässiger
Emissionen monochromatischer oder auch breitbandiger
Störer oder auch für den Personenschutz, insbesondere
als Strahlenschutz im Mikrowellenbereich, benötigt.
Die Schirmwirkung beruht auf zwei Effekten: An der
Schirmoberfläche wird ein Teil der auffallenden Strahlung reflektiert und bei dem in das Medium eindringenden
Teil der Strahlung tritt beim Durchgang durch den
Schirm eine ständige Absorption ein. Bei einem Schirmmaterial wird einerseits versucht, ihm eine hohe Leitfähigkeit und eine Mindestdicke zu geben (Metallschirm),
damit die Reflexion hoch ist; Probleme können an Stoßstellen auftreten; bei nicht einwandfreier nahtloser

Le A 20 388-Ausland

- 2 -

großflächiger Kontaktierung können Streufelder in den abgeschirmten Raum eintreten. Man versucht andererseits, den Schirm als "schwarzen Körper" auszubilden, der alle Strahlung absorbiert und in Wärme umwandelt. Dabei ließen sich Oberflächenströme vermeiden und es entfielen Kontaktierungsprobleme. Ein universell brauchbares Schirmmaterial kann es aber nicht geben, weil der Wellenwiderstand des Fernfeldes nicht die gleichen Werte hat wie im Nahfeld, es aber andererseits Voraussetzung ist, daß bei einem schwarzen Körper der Wellenwiderstand des Raumes an den Flächenwiderstand des Körpers angepaßt ist.

Aufgabe der Erfindung ist ein Material mit einer hohen Schirmwirkung für elektromagnetische Strahlung. Das Material soll möglichst billig sein, die Wandstärke niedrig, das Material flexibel, gegebenenfalls spritzgussfähig und zur Abschirmung insbesondere von elektromagnetischer Strahlung im Frequenzbereich von $10^4$ bis $10^{11}$ Hz sowohl im Nah- als auch im Fernfeld geeignet sein. Bei magnetischer Einstreuung kann auch der Frequenzbereich um 50 Hz wichtig sein.

Die Aufgabe wird von einem Verbundmaterial gelöst das dadurch gekennzeichnet ist, daß in einer Polymermatrix metallisierte textile Flächengebilde und/oder metallisierte Teilchen enthalten sind und zudem gleichmäßig im Polymer oder auf den textilen Flächengebilden und/oder Teilchen Additive zur Erhöhung der ohmschen, elektrischen und/oder magnetischen Verluste vorhanden sind. Weitere vorteilhafte Ausbildungen sind

Le A 20 388

in den Unteransprüchen beschrieben.

Das erfindungsgemäße Material hat eine unerwartet hohe Schirmwirkung. Aus der DE-OS 2 847 486 ist bekannt, das metallisierte textile Flächengebilde als Strahlenschutz gegen Mikrowellen verwendet werden können. Auch ist bereits bekannt, daß die spezifische elektrische Leitfähigkeit eines textilen Flächengebildes viel höher ist, wenn die Metallschicht naßchemisch stromlos niedergeschlagen worden ist, als wenn eine gleichgroße Menge Metall aufgedampft oder aufgestäubt wäre, weil die einzelnen Fasern gleichmäßig (auch in den abgeschatteten Partien) mit Metall bedeckt sind. Jedoch ist überraschend, daß durch die Matrix aus Polymeren, also durch die Einkaschierung des Gewebes, die Schirmwirkung beträchtlich gesteigert werden kann. Im Gegensatz zu der an sich bekannten Absorptions- und Reflexionswirkung eines textilen Flächengebildes oder eines Metallschirmes zeigt sich auch, daß es nicht unbedingt auf eine möglichst lückenlose gleichmäßige oberflächliche Metallisierung von Flächengebilden, oder auch einer entsprechend dichten Ansammlung von Teilchen, ankommt. Die schirmende Wirkung wird sogar noch verstärkt, wenn die Metallisierung nicht gleichmäßig ist, und wenn die Additive zur Erhöhung der ohm'schen, elektrischen und/oder magnetischen Verluste nicht gleichmäßig in der Matrix sondern bevorzugt auf den textilen Flächengebilden und/oder Teilchen vorhanden sind.

Le A 20 388

Die Begriffe textile Flächengebilde und Teilchen sind weit auszulegen. Unter textilen Flächengebilden sollen Gewebe, Gestricke, Gewirke, Vliese, Filze, Papiere, Faserfeinschnitt; unter Teilchen beispielsweise flächige, kugelige oder stäbchenförmige (z.B. Einzelfasern) die auch ein Profil, z.B. trilobat, haben können, verstanden werden, die Teilchen können Pigmente oder Leitruß sein. Es ist günstig, wenn die Teilchen selbst elektrische und/oder magnetische verlustbehaftete Dielektrika sind. Die Matrix, das Harz, sollte so ausgewählt werden, daß sie auch verlustbehaftet ist; in einem nicht-leitfähigen Harz können durch Zusätze, z.B. von Leitruß oder von organischen Metallen, z. B. Tetrathiofulvalen-Tetracyanochinodimethan oder natriumdotiertes Polyacetylen eingebaut werden. Die Leitfähigkeiten sollten vorzugsweise im Bereich $10^{-2}$ bis $10^{4}$ (Ohm$^{-1}$ cm$^{-1}$) liegen. Darüber hinaus kann das Material mit Deckschichten kaschiert werden, die auch absorbierenden Charakter haben können.

Die Erfindung ist weiter beispielhaft beschrieben und in der Zeichnung dargestellt. Es zeigen:

Fig. 1 Draufsicht auf ein Verbundmaterial mit einem metallisierten Gewebe;

Fig. 2 Schnitt durch ein Verbundmaterial mit einem metallisierten Gewebe;

Fig. 3 Verbundmaterial mit Faserkurzschnitt;

Fig. 4 Verbundmaterial mit metallisierten Teilchen.

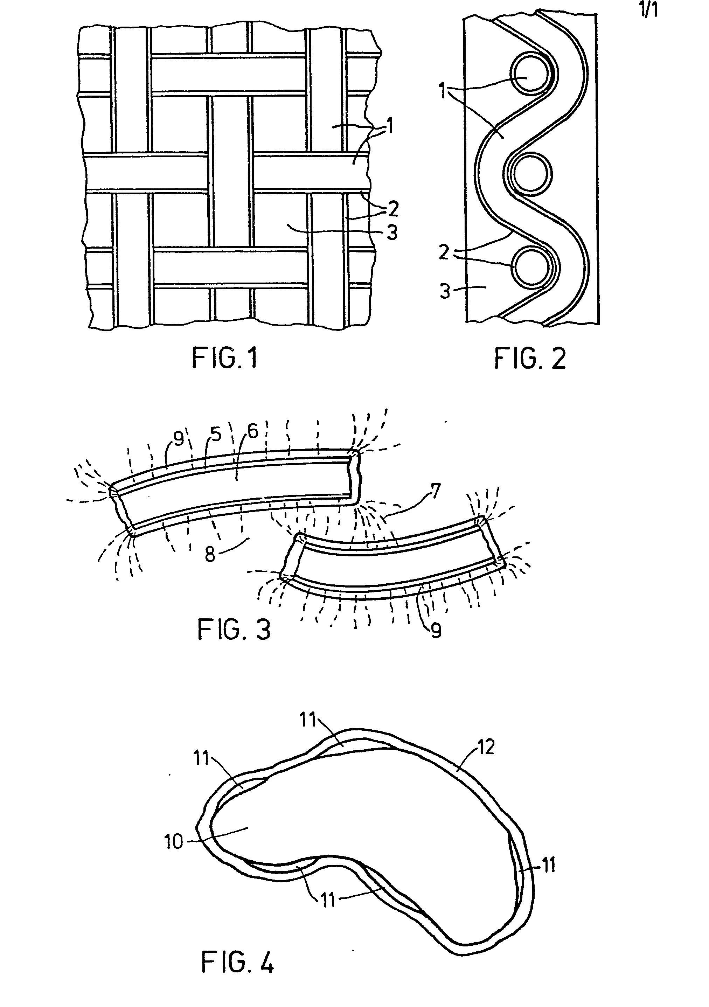

Die Fasern 1 in Fig. 1 und 2 sind mit einer 0,6µ dicken Nickelauflage 2 versehen. In diesem Beispiel handelt es sich um Polyacrylnitrilspinnfasern in einem Wevenit-Gestrick. Das textile Flächengebilde ist einkaschiert in Weich-PVC 3, dem 10 % Leitruß zugesetzt sind. Die Gesamtdicke des Verbundmaterials beträgt 0,75 mm. Die Schirmwirkung dieses Materials im Bereich von $5 \times 10^7$ bis $10^{11}$ Hz ist aus Tabelle 1 erkennbar. Die Mindestdämpfung beträgt 45 dB. Das Material ist nicht vollkommen isotrop. Zur Messung der Schirmdämpfung wird linear polarisierte Strahlung verwendet. In der Tabelle 1 sind die Absorptionswerte mit dem E-Vektor parallel und senkrecht zur Stäbchenrichtung angegeben, die etwa mit den kleinsten und größten Werten übereinstimmen.

Bei diesem Beispiel wurde auch die Schirmdämpfung der Komponenten gemessen. Das kaschierte, unmetallisierte Gestrick liefert eine Schirmdämpfung von etwa 1 dB; das metallisierte, aber unkaschierte Gestrick 21 dB im Bereich 11 bis 12 GH$_z$. Für die Kombination Kaschierung und Metallisierung ergibt sich ein sehr hoher Anstieg.

Tabelle 1

| Frequenz in GHz | 0,05 | 1-1,5 | 2-2,4 | 8-9 | 11-12 | 35-26 |
|---|---|---|---|---|---|---|
| Dämpfung in dB (1) | 51 | 46 | 46 | 46 | 48 | 45 |
| Dämpfung in dB (2) | 55 | 55 | 55 | 65 | 65 | 60 |

In einem weiteren Beispiel wird ein Spinnfasergewebe aus gleichen Anteilen Polyester und Baumwolle mit ei-

Le A 20 388

- 6 -

ner 0,5μ dicken Nickelauflage stromlos naßchemisch beschichtet. Das metallisierte Gewebe wurde mit einem Weich-PVC, der etwa 15 % Leitruß enthielt, kaschiert. Das Verbundmaterial war 0,25 mm dick. Die Schirmdämpfung ist in der Tabelle 2 dargestellt. Das unmetallisierte, kaschierte Gewebe lieferte nur 0,9 dB Schirmdämpfung, das metallisierte, aber unkaschierte Gewebe 16 dB. Die Schirmdämpfung ist bei diesem Gewebe einmal wegen der um den Faktor 3 geringeren Materialstärke kleiner, zum anderen durchsetzt der Flächenstrom bei einem Gewebe weniger kapazitive Kontaktstellen pro Flächeneinheit als bei dem Gestrick. Die Dämpfung ist bei linearer Polymerisation parallel zur Kett- bzw. Schußrichtung gemessen.

Bei dem erfindungsgemäßen Verbundmaterial ist das Hochfrequenzfeld durch den in der metallisierten Struktur induzierten Strom viel stärker in der verlustbehafteten Matrix konzentriert. Zusätzlich wird der Stromfluß in der metallisierten Struktur in vielfältiger Form geteilt und unterbrochen. In Fig. 3 sind zwei teilmetallisierte längliche Teilchen dargestellt. Es handelt sich um Faserfeinschnitt, der nach der Metallisierung zerschnitten worden ist. Die Metallschichten 5 auf den Fasern 6 berühren sich nicht. An den Kanten ist die Feldstärke besonders hoch, was in Fig. 3 durch eine besonders hohe Feldliniendichte 7 angedeutet ist. Die dielektrischen Verluste pro Volumeneinheit sind bekanntlich proportional zum Quadrat der elektrischen Feldstärke. Die Stärke der Monofile war in diesem Beispiel 0,5 bis 5μm, die Metallisierung zwischen

Le A 20 388-Ausland

0,05 und 0,5µm und die Länge der Fasern zwischen 0,5 und 5 mm. Das Monofil kann eine Glasfaser oder auch eine synthetische oder native organische Faser sein. Es hat sich herausgestellt, daß ähnlich hohe Schirmdämpfungen wie in Tabelle 2 auch erreicht werden, wenn die Metallisierung erst nach dem Kurzschnitt durchgeführt wird. Die Fasern in Fig. 3 sind in einem leitfähigen PVC eingebettet, das 12 bis 15 % Leitruß enthält. Typische Füllfaktoren gehen bis ca. 30 %.

Tabelle 2

| Frequenz in GHz | 0,05 | 1-1,5 | 2-2,4 | 8-9 | 11-12 | 35-36 |
|---|---|---|---|---|---|---|
| Dämpfung in dB (1) | 33 | 26 | 22 | 24 | 25 | 27 |
| Dämpfung in dB (2) | 44 | 41 | 37 | 33 | 37 | 31 |

Eine besondere Ausrichtung der Monofile ist im allgemeinen nicht erwünscht, um eine isotrope Wirkung unabhängig von der Polarisation der elektrischen oder magnetischen Felder zu erreichen. Die metallisierten Teilchen sind in diesem Beispiel noch mit einer verlustbehafteten Schicht 9 überzogen worden, bevor sie in die Harzmatrix eingearbeitet worden sind. Das ist deswegen von besonderem Vorteil, weil die Zugabe von Additiven zur Harzmatrix in der Regel durch die erforderliche Festigkeit des Materials begrenzt ist, während die verlustbehafteten Zuschläge, wie Leitruß, Graphit, Ferrit ohne Rücksicht auf die mechanischen Festigkeitsforderungen direkt auf den metallisierten

Le A 20 388

Teilchen- bzw. Flächengebilden aufgebracht werden können.

In Fig. 4 ist ein teilmetallisiertes Pigmentteilchen dargestellt. Der Grundkörper 10, z.B. aus Ferrit, Leitruß oder einem "organischen Metall", z.B. Tetrathiofulvalen-Tetracyanochinodimethan ist teilmetallisiert. Durch eine Impfung mit Palladiumkeinem oder -ionen wird eine dünne lückenhafte Metallisierung (z.B. mit Ko-baltnickel, Nickeleisenlegierung, Kobaltnickellegie-rung, Kupfer) des Grundkörpers 10 erreicht, wobei die in den deutschen Offenlegungsschriften 2 739 179, 2 743 768, 2 749 151, 2 804 031, 2 820 502, 2 820 525 beschriebene Badbehandlung entsprechend gekürzt wird. Um dieses Teilchen ist wieder eine Schicht 12 eines geeigneten Additivs (entsprechend oben Schicht 9) aufgebracht. Dadurch lassen sich die dielektischen und magnetischen Verluste des Grundkörpers in wesentlich weiteren Bereichen variieren als wenn das Additiv zum Harz zugegeben worden wäre. Die von den metallisierten Bezirken ausgehenden elektrischen Streufelder verlaufen vorzugsweise im Bereich des Grundkörpers, insbesondere, wenn der Realteil der Dielektrizitätskonstanten groß gegenüber der Harzmatrix ist.

Ein teilmetallisiertes textiles Flächengebilde ist analog wie das in Fig. 4 dargestellte Teilchen aufgebaut. Besonders ein Kohlenstoffasergewebe ist dafür besonders geeignet.

Le A 20 388-Ausland

Ein Kohlenstoffasergewebe, sei es auf Basis Bitumen, Cellulose oder Polyacrylnitril-Filamenten hergestellt, wird vernickelt. Bereits bei geringer Metallaufnahme von ca. 7 % Nickel wird eine überraschend hohe Absorption in Transmission, verbunden mit einem sehr geringen Reflexionsverlust, gemessen. Das vernickelte Kohlenstoffasergewebe zeigte nach der Vernickelung folgende Werte:

Tabelle 3

| Frequenz in Ghz | 1-1,5 | 1-2,4 | 7-8 | 11-12 | 35-36 |
|---|---|---|---|---|---|
| Dämpfung in dB | 55 | 48 (50) | 40 (42) | 41 (43) | 46 (48) |

Die Werte in Klammern bedeuten eine Drehung der Probe um 90°.

Diese Ergebnisse bleiben erhalten, wenn man das vernickelte Kohlenstoffasergewebe anschließend in Epoxidharz oder Polyimidharzen einbettet. Eine partielle Metallisierung kann z.B. durch Hydrophobierung oder Beschichtung bzw. Bedrucken, mit nicht benetzbaren Substanzen erreicht werden.

Teilweise metallisierte textile Flächengebilde, auch partiell metallisierte textile Flächengebilde genannt, können nach verschiedenen Verfahren hergestellt werden. Z.B. hydrophobiert man die nicht zu metallisierenden

Le A 20 388

Bereiche, d.h. man führt entweder eine wasserabstoßende Behandlung des Gewebes vor der Aktivierung durch, oder man desaktiviert, d.h. man behandelt die aktivierten Bereiche mit den Katalysator vergiftenden Chemikalien, wie z.B. verdünnter Chrom-Schwefelsäure, so daß dort eine Metallisierung im Metallisierungsbad nicht mehr vorkommen kann.

Die partielle Metallisierung kann aber auch so vorgenommen werden, daß man ausgewählte Bereiche mit dem Katalysator behandelt, z.B. mit einem Pinsel bestreicht oder nur bereichsweise in die Katalysatorlösung eintaucht, besprüht oder bedruckt, so daß Bereiche übrigbleiben, die keinen Katalysator enthalten und somit im nachfolgenden Metallsalz-Bad keine reduktive Metallabscheidung erleiden, also unmetallisiert bleiben.

Le A 20 388

Patentansprüche

1) Verbundmaterial, dadurch gekennzeichnet, daß in einer Polymermatrix (3,8) metallisierte (2) textile Flächengebilde und/oder metallisierte (5,11) Teilchen (6,10) enthalten sind und zu dem gleichmäßig im Polymer (3,8) oder auf dem textilen Flächengebilde und/oder Teilchen Additive (9,12) zur Erhöhung der ohmschen, elektrischen und/oder magnetischen Verluste vorhanden sind.

2) Verbundmaterial nach Anspruch 1, dadurch gekennzeichnet, daß die textilen Flächengebilde und/oder Teilchen wenigstens teilweise mit einer naßchemisch, stromlos abgeschiedenen hochleitfähigen Metallschicht von 0,05 bis 20 μm Dicke umgeben sind.

3) Verbundmaterial nach Ansprüchen 1 und 2, dadurch gekennzeichnet, daß auf dem textilen Flächengebilde und/oder Teilchen unmetallisierte Bereiche vorhanden sind, wodurch die metallisierten Bereiche durch Abstände von vorzugsweise 0,1 bis 10 μm getrennt sind.

4) Verbundmaterial nach Ansprüchen 1 bis 3, dadurch gekennzeichnet, daß die Schichtdicke 0,05 bis 20 mm beträgt.

Le A 20 388 -Ausland

5) Verbundmaterial nach Ansprüchen 1 bis 4, dadurch gekennzeichnet, daß die Leitfähigkeit des textilen Flächengebildes $10^{-2}$ bis $10^4$ Ohm$^{-1}$ cm$^{-1}$ beträgt.

6) Verbundmaterial nach Ansprüchen 1 bis 4, dadurch gekennzeichnet, daß die Leitfähigkeit der Polymermatrix $10^{-2}$ bis $10^4$ Ohm$^{-1}$ cm$^{-1}$ beträgt.

7) Verbundmaterial nach Ansprüchen 1 bis 6, dadurch gekennzeichnet, daß die Additive zur Erhöhung der ohmschen, dielektrischen und/oder magnetischen Verluste auf den textilen Flächengebilden und/oder Teilchen in einer Schicht mit einer Dicke vorzugsweise zwischen 0,1 bis 10µm aufgebracht sind.

8) Verbundmaterial nach Anspruch 7, dadurch gekennzeichnet, daß die Schicht aus organischen Pigmenten oder halbleitendem anorganischem Material besteht und die Leitfähigkeit dieser Schicht vorzugsweise $10^0$ bis $10^4$ Ohm$^{-1}$ cm$^{-1}$ beträgt.

9) Verbundmaterial nach Ansprüchen 1 bis 8, dadurch gekennzeichnet, daß das Material noch außen beschichtet ist.

10) Verwendung des Verbundmaterials nach Anspruch 1 bis 9 als Schirmmaterial gegen elektromagnetische Strahlen im Bereich von 10 kHz bis 1000 GHz.

Le A 20 388

FIG. 1

FIG. 2

FIG. 3

FIG. 4

0043040

Nummer der Anmeldung

**Europäisches Patentamt**

**EUROPÄISCHER RECHERCHENBERICHT**

EP 81 10 4699.4

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | DE – A1 – 2 819 377 (IBM) <br> * Ansprüche 1, 6, 7, 10; Seite 6, Zeile 1 bis Seite 10, Zeile 24 * <br> -- | 1 |
| | DE – A1 – 2 827 676 (CHOMERICS) <br> * Anspruch 1; Seite 5, Zeile 1 bis Seite 6, Zeile 6; Seite 11, Zeilen 16 bis 27; Fig. 1 bis 7 * <br> * Seite 12, Zeilen 7 bis 9 * <br> -- | 1 <br><br><br> 6 |
| | US – A – 3 752 899 (BAKKER) <br> * Anspruch 1; Spalte 1, Zeilen 49 bis 61 * Fig. 1 * <br> -- | 1 |
| D | DE – A1 – 2 847 486 (BAYER) <br> * Anspruch 1 * <br> -- | 2,10 |
| A | EP – A1 – 0 007 701 (ALLIED CHEMICAL CORP.) <br> * Ansprüche 1, 2; Seite 14, Zeile 24 bis Seite 15, Zeile 8; Fig. 1, 2 * <br> -- | |
| A | US – A – 4 126 287 (MENDELSOHN et al.) <br> * Spalte 2, Zeilen 45 bis 63; Spalte 4, Zeilen 4 bis 24; Fig.1 * <br> ---- | |

### KLASSIFIKATION DER ANMELDUNG (Int. Cl.³)

H 05 K 9/00
H 01 B 1/20
H 01 B 5/16

### RECHERCHIERTE SACHGEBIETE (Int. Cl.³)

G 12 B 17/00
G 12 B 17/02
H 01 F 1/113
H 01 B 1/02
H 01 B 1/06
H 01 B 1/20
H 01 B 5/16

### KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

| X | Der vorliegende Recherchenbericht wurde für alle Patentansprüche erstellt. |
|---|---|

| Recherchenort | Abschlußdatum der Recherche | Prüfer |
|---|---|---|
| Berlin | 24-09-1981 | HAHN |

EPA form 1503.1 06.78